(19)

Europäisches
Patentamt

European
Patent Office

Office européen
des brevets

(11)  **EP 4 009 060 A1**

(12)  **EUROPEAN PATENT APPLICATION**

(43)  Date of publication:
08.06.2022   Bulletin 2022/23

(21)  Application number: 20211317.1

(22)  Date of filing: 02.12.2020

(51)  International Patent Classification (IPC):
$G01R\ 21/00^{(2006.01)}$    $H04B\ 17/10^{(2015.01)}$
$H03F\ 3/393^{(2006.01)}$    $H03F\ 3/45^{(2006.01)}$

(52)  Cooperative Patent Classification (CPC):
**H03F 3/393; G01R 21/01; H03F 3/4508;**
**H03F 3/45179; H03F 3/45475;** H03F 2200/261;
H03F 2203/45318; H03F 2203/45394

(84)  Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71)  Applicant: **NXP B.V.**
**5656 AG Eindhoven (NL)**

(72)  Inventors:
• **Op  t Eynde, Frank**
**Redhill, Surrey RH1 1QZ (GB)**
• **Hoogzaad, Gian**
**Redhill, Surrey RH1 1QZ (GB)**
• **Hummel, Fabian van**
**Redhill, Surrey RH1 1QZ (GB)**

(74)  Representative: **Miles, John Richard**
**NXP SEMICONDUCTORS**
**Intellectual Property Group**
**Abbey House**
**25 Clarendon Road**
**Redhill, Surrey RH1 1QZ (GB)**

(54)  **RF  POWER DETECTOR**

(57)    A Radio Frequency (RF) power detector and method is described, an RF input is configured to receive an RF signal and a chopper coupled to the RF input is configured to output a chopped RF signal. A non-linear element is configured to receive the chopped RF signal and to output a signal corresponding to an RMS power level of the RMS signal. A variable gain amplifier and filter includes an input coupled to the non-linear amplifier output and a variable gain amplifier output to filter and adapt the gain of a signal received from the non-linear amplifier output. A de-chopper is coupled to the variable gain amplifier and provides a signal corresponding to the RF power of the received RF signal.

FIG. 1

**EP 4 009 060 A1**

**Description**

FIELD

This disclosure relates to a method and apparatus for radio frequency (RF) power detection

BACKGROUND

Integrated RF power detectors are used in products either when required by the application or when required for testing. RF power detectors are used for example to measure and control the RF power in wireless communication systems either by measuring the transmitter power or determining the received signal strength indication (RSSI). These measurements are typically used to adjust the gain of one or more amplifiers in the respective transmit/receive paths. During testing of an RF transmitter/receiver, an RF power detector may be used for example to calibrate the gain of variable gain amplifiers in a transmit/receiver chain to account for manufacturing variances.

SUMMARY

Various aspects of the disclosure are defined in the accompanying claims. In a first aspect there is provided an RF power detector comprising; an RF input configured to receive an RF signal; a chopper coupled to the RF input and configured to output a chopped RF signal; a non-linear element configured to receive the chopped RF signal; and to output a signal corresponding to an RMS power level of the RMS signal; a variable gain amplifier and filter having an input coupled to the non-linear amplifier output and a variable gain amplifier output and configured to filter and adapt the gain of a signal received from the non-linear amplifier output; a de-chopper coupled to the variable gain amplifier and configured to provide a signal corresponding to the RF power of the received RF signal.

In one or more embodiments, the non-linear element is configured as a non-linear amplifier, the non-linear amplifier comprising a bipolar transistor having a base coupled to the output of the chopper via a capacitor, a collector coupled to the input of the variable gain amplifier and a resistance arranged between a bias supply rail and the transistor base.

In one or more embodiments, the chopper may comprise a first switch arranged between the RF input and the chopper output and a second switch arranged between a reference supply and the chopper output and wherein the chopper is configured to couple the RF input to the chopper output during a first phase of a clock signal and to couple the reference supply to the chopper output during a second phase of the clock signal.

In one or more embodiments, the variable gain amplifier and filter may comprise a plurality of variable gain amplifier stages.

In one or more embodiments, the variable gain amplifier stage may comprise a serial arrangement of a first capacitance and a first switch between a variable gain amplifier stage input and an inverting input of an operational amplifier; a second switch arranged between a supply node and a common node with the first capacitance and the first switch; a second capacitance coupled between the variable gain amplifier stage input and the inverting input of an operational amplifier; a parallel arrangement of a third capacitance and resistance between the operational amplifier output and the operational amplifier inverting input and a ground node coupled to the operational amplifier non-inverting input.

In one or more embodiments, the de-chopper may be coupled to the variable gain amplifier via an analog to digital converter and configured to digitally de-chop the output signal of the variable gain amplifier to provide the RF power signal.

In one or more embodiments, the chopper may comprise a first and second chopper output, the non-linear element is configured as a differential non-linear amplifier, the variable gain amplifier comprises a pair of inputs and outputs, the de-chopper comprises a pair of de-chopper inputs and a pair of de-chopper outputs.

In one or more embodiments, the differential non-linear amplifier may comprise a pair of bipolar transistors having a base coupled to a respective output of the chopper via a respective capacitor, a collector coupled to a respective input of the variable gain amplifier and a respective resistance arranged between a bias supply rail and the transistor base.

In one or more embodiments, the chopper may comprise a first switch arranged between the RF input and the first chopper output, a second switch arranged between a reference supply and the chopper output, a third switch arranged between the RF input and the second chopper output, a fourth switch arranged between a reference supply and the chopper output, wherein the chopper is configured to couple the RF input to the first chopper output and to couple the reference supply to the second chopper output during a first phase of a clock signal and to couple the RF input to the second chopper output and the reference supply to the first chopper output during a second phase of the clock signal.

In one or more embodiments, the variable gain amplifier may comprise one or more variable gain amplifier stages, each variable gain amplifier stage comprising: a parallel arrangement of a first capacitance and resistance between the inverting operational amplifier output and the operational amplifier non-inverting input; and a parallel arrangement of: a first serial arrangement of a second capacitance and a first switch between a first variable gain amplifier stage input and a non-inverting input of an operational amplifier; a second serial arrangement of a third capacitance and a second switch between the first variable gain amplifier stage input and the non-inverting input of the operational amplifier; and a third capacitance coupled between the first variable gain amplifier stage input and a non-inverting input of an operational amplifier; and each variable gain amplifier stage further comprising: a parallel arrangement of a fifth capacitance and resistance between the operational amplifier non-inverting output and the operational amplifier inverting input; and a parallel arrangement of: a third serial arrangement of a sixth capacitance and a third switch between a second variable gain amplifier stage input and the inverting input of the operational amplifier; a fourth serial arrangement of a seventh capacitance and a fourth switch between the second variable gain amplifier stage input and the inverting input of the operational amplifier; an eighth capacitance coupled between the second variable gain amplifier stage input and the inverting input of the operational amplifier.

In one or more embodiments, the de-chopper may comprise a first switch arranged between the first variable gain amplifier output and the first de-chopper output, a second switch arranged between the first variable gain amplifier output and the second de-chopper output, a third switch arranged between the second variable gain amplifier output and the first de-chopper output, a fourth switch arranged between the second variable gain amplifier output and the second de-chopper output, wherein the de-chopper is configured to couple the first variable gain amplifier output to the first de-chopper output and to couple the second variable gain amplifier output to the second de-chopper output during an active phase of a first clock signal and configured to couple the first variable gain amplifier output to the second de-chopper output and to couple the second variable gain amplifier output to the first de-chopper output during an active phase of a second clock signal, wherein the active phases of the first and second clock signals are non-overlapping.

In one or more embodiments, the RF power detector may further comprise a low pass filter coupled to the de-chopper outputs.

In one or more embodiments, the low pass filter may further comprise a series arrangement of a resistance and a capacitance coupled between each RF power detector output and a ground node.

In one or more embodiments, The RF power detector of any of claims may further comprise an analog-to-digital convertor coupled to the RF power detector output.

In one or more embodiments, the non-linear element may comprise one of a non-linear bipolar transistor amplifier, a non-linear MOS transistor amplifier, a gilbert-cell multiplier.

In one or more embodiments, the de-chopper may be coupled to the variable gain amplifier via an ADC and is configured to digitally de-chop the signal received from the variable gain amplifier.

In one or more embodiments, the differential non-linear amplifier may comprise a pair of MOS transistors having a gate coupled to a respective output of the chopper via a respective capacitor, a drain coupled to a respective input of the variable gain amplifier and a respective resistance arranged between a bias supply rail and the transistor gate.

In one or more embodiments, the RF power detector may be included in an RF transceiver including an RF power amplifier configured to receive the RF signal, and a controller coupled to the RF power detector and the RF power amplifier; wherein the controller is configured to determine an RF power value from the de-chopped signal and to calibrate the gain of the RF power amplifier based on the RF power value.

In a second aspect, there is provided a method of RF signal power detection comprising: receiving an RF signal; chopping the RF signal; converting the chopped RF signal to DC current with a non-linear element configured as an RMS detector; filtering and adapting the gain of the DC current signal; de-chopping the filtered DC current signal to provide a de-chopped signal corresponding to the RF power of the received RF signal.

In one or more embodiments, the method of RF signal power detection may be included in a method of calibrating the gain of an RF power amplifier. The calibration method may further comprise determining an RF power level value from the de-chopped signal and calibrating the RF amplifier based on the determined RF power level.

BRIEF DESCRIPTION OF THE DRAWINGS

In the figures and description like reference numerals refer to like features. Embodiments are now described in detail, by way of example only, illustrated by the accompanying drawings in which:

Figure 1 shows a RF power detector according to an embodiment.

Figure 2 illustrates a chopper circuit of the RF detector of figure 1.

Figure 3A shows a variable gain amplifier and filter circuit of the RF detector of figure 1.

Figure 3B illustrates the frequency response of the variable gain amplifier and filter circuit of figure 3A.

Figure 4 shows a RF power detector according to an embodiment.

Figure 5A illustrates a chopper circuit of the RF detector of figure 4.

Figure 5B illustrates a de-chopper circuit and low pass filter circuit of the RF detector of figure 4.

Figure 5C illustrates example clock waveforms for the chopper circuit of figure 5A and de-chopper circuit of figure 5B.

Figure 6 shows a variable gain amplifier and filter circuit of the RF detector of figure 4.

Figure 7 shows a RF power detector according to an embodiment.

Figure 8 shows a RF power detector including a gilbert multiplier according to an embodiment.

Figure 9 illustrates a method of RF power detection according to an embodiment.

DETAILED DESCRIPTION OF EMBODIMENTS

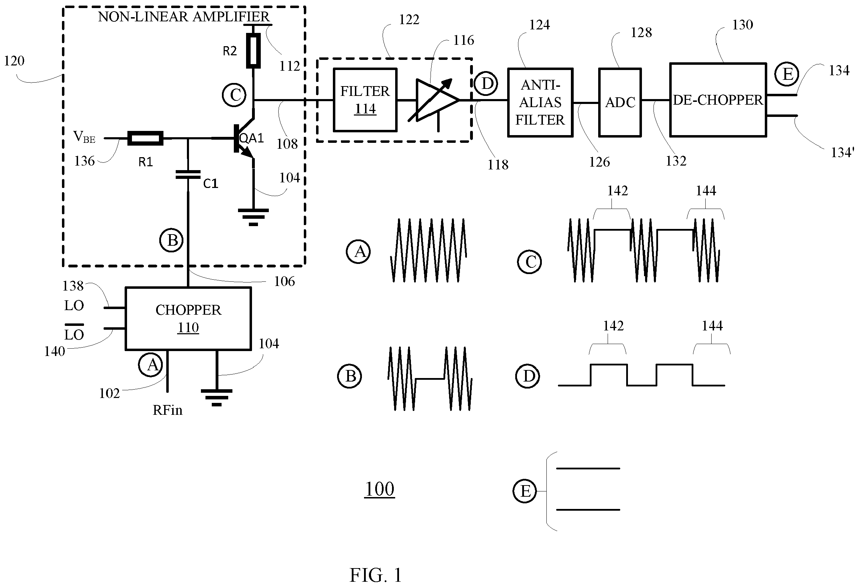

Figure 1 shows an RF power detector 100 according to an embodiment. The RF power detector 100 includes a chopper 110, a non-linear amplifier 120, a variable gain amplifier and filter 122, an anti-alias low-pass filter 124, an analog-to-digital converter (ADC) 128, and a de-chopper 130.

The chopper 110 has a first input connected to an RF input 102 and a second input connected to a ground node or ground rail 104. The chopper 110 has a first chopper clock input 138 and a second chopper clock input 140. The first chopper clock input 138 may be configured to receive a clock LO and the second chopper clock input 140 may be configured to receive a second clock $\overline{LO}$ which is the inverse of LO. The chopper output 106 may be connected to an input of the non-linear amplifier 120.

The non-linear amplifier 120 may include an NPN bipolar transistor QA1 having a base connected to a bias voltage supply 136 via a resistor R1. The base of QA1 may also be connected to the chopper output 106 via a capacitor C1. The emitter of transistor QA1 may be connected to the ground node 104. The collector of the transistor QA1 may be connected to the non-linear amplifier output 108 and may also be connected to a supply voltage node or supply voltage rail 112 via a resistor R2.

The non-linear amplifier output 108 may be connected to a filter 114 which may be a bandpass or high pass filter. The output of the filter 114 may be connected to a variable gain amplifier element 116. The variable gain amplifier element 116 and filter 114 may be combined in a single variable gain amplifier 122. The variable gain amplifier output 118 may be connected to an input of the anti-alias (low pass) filter 124. The anti-alias filter output 126 may be connected to an input of the ADC 128. The ADC output 132 may be connected to the input of the de-chopper 130. The de-chopper outputs may be connected to the RF detector outputs 134, 134'.

In operation, the RF detector 100 may receive an RF signal on the RF input 102 shown as an example waveform A. The chopper 110 may chop the RF signal at a frequency ($f_{LO}$) which is much less than the RF frequency, for example a frequency of 1 MHz giving the output as shown in waveform B. The chopping frequency clocks may have a 50% duty cycle. The non-linear amplifier 120 together with the chopper 110 converts the RF signal of interest from the RF frequency to a DC current with a 50% duty cycle square wave at the chopper frequency ($f_{LO}$). The non-linear amplifier output 108 provides a signal which corresponds to the RMS voltage level of the RF signal shown as waveform C. The filter 114 may be a band-pass filter which may remove the remaining RF frequencies from the waveform and also the DC-offset of the non-linear amplifier. The variable gain amplifier 116 may adjust the gain of the signal to the dynamic range of the ADC 128. The signal at the variable gain amplifier output 118 corresponds to the waveform D which is a pulse train at the chopper frequency $f_{LO}$ having a low value and a high value. The difference between the low value and the high value may correspond to the RMS voltage of the RF input signal received on the RF input 102. The variable gain amplifier output 118 may be digitised via anti-alias filter 124 and ADC 128. The chopper 130, which in this example is a digital de-chopper, may then determine values of the low value and the high value of waveform D as illustrated by waveform E. The sample frequency of the ADC has to be greater than twice the chopper frequency $f_{LO}$. Subsequent digital processing may then determine value of RF power from the difference between the low and high values.

The RF power detector 100 may provide true RF RMS power detection with a large dynamic range which may for example 50 dB compared to typical power detectors which have a dynamic range of about 20 dB. The RF power detector 100 chops the signal to remove DC offsets at the non-linear amplifier output 108 which allows a more accurate power detector with wide dynamic range. In particular an RF power detector may require a wider dynamic range during testing. This wider dynamic range enables testing of the product's gain range e.g. provided by a Variable Gain Amplifier or Digital Step Attenuator in the RF amplifier line-up. A wider dynamic range may also make the power detector less sensitive for spread of the Device Under Test, hence less calibration is needed to get the measurement within range.

For example, assume that the input power ranges from -80 dBm to -30 dBm. Converting a power of -80 dBm to voltage gives $V_{in,RMS} = \sqrt{10^{-11} \cdot 50} = 22\ \mu V$ when applied to a $50\Omega$ matching impedance. This voltage is the smallest input voltage that must be properly detected by the power detector. However, DC offsets in transistors such as MOS or Bipolar transistors may exceed 1mV and thus DC offsets may decrease the dynamic range significantly.

The non-linear amplifier 120 uses the non-linearity of a bipolar transistor to perform RMS-power detection and to perform RF to DC conversion.

For the non-linear amplifier 120, the DC collector current $\overline{I_c}$ due to a DC bias voltage and RF input voltage without chopping can be written as:

$$\overline{I_c(t)} = I_o + \Delta I \tag{1}$$

Where $I_o$ is generated by the DC bias voltage $V_{BE}$ and $\Delta I$ is generated by the RF input voltage. Furthermore, $\Delta I$ can be approximated by:

$$\Delta I \approx I_o \cdot \frac{1}{2} \cdot \left(\frac{v_{ac,rms}}{U_T}\right)^2 \tag{2}$$

In the above expressions, $U_T = \frac{kT}{q}$ is the thermal voltage and $I_o = I_S \cdot e^{\frac{V_{BE}}{U_T}}$

In Equation 2 it is seen that the RF RMS voltage at the input of a bipolar transistor without chopping generates a DC output current. RMS detection and RF to DC conversion is done by chopping the RF signal before the input of the non-linear amplifier 120. The DC collector current $I_c(t)$ of the bipolar transistor corresponding to the output current of the non-linear amplifier depends on the chopper state as illustrated by Equation 3:

$$RF \rightarrow \overline{I_c(t)} = I_o + \Delta I$$
$$No\ RF \rightarrow \overline{I_c(t)} = I_o \tag{3}$$

From Equation 3 it is seen that the DC current in the non-linear amplifier is increased when the RF is applied and decreased when the RF is not applied. Because of this, a 50% duty cycle square wave at $f_{LO}$ is generated at the output 108 of the non-linear amplifier 120. Waveform C illustrates the voltage waveform at the non-linear amplifier output 108 given by

$$V_c = V_{supply} - I_c R_2 \tag{4}$$

Where $V_c$ is the collector voltage of Q1 which is also the output voltage at the non-linear amplifier output 108 and $V_{supply}$ is the supply voltage at supply node 112. The output voltage is the inverse of the collector current $I_c$. Consequently region 144 is a level representing the RF power level (once filtered) and region 142 corresponds to a reference level. Referring to waveform D, the absolute difference between the reference level at region 142 and the lower level at region 144 which includes the RF power information corresponds to the RF power level.

Furthermore as the signal information is not at DC, the DC offsets can now be removed using a high-pass filter. Thus, by having a chopper 110 and non-linear amplifier 120, the inventors of the present disclosure have appreciated that RMS power can be accurately measured over a large dynamic range.

Referring back to Equation 2 it can be seen that $\Delta I$ depends quadratically on the RF RMS input voltage. Thus, if the required dynamic range at the input is 50 dB, the required dynamic range at the output is 100 dB.

An ADC typically has a much lower dynamic range then 100 dB. By using variable gain amplifier 116 after the RMS detector using the non-linear amplifier 120, the output signal of the variable gain amplifier may be digitized by ADC 128 over a dynamic range of 100 dB. The gain of the variable gain amplifier may be relatively large for small input signals and relatively small for larger input signals.

The RF power levels determined using RF power detector 100 may be used for a one-point calibration of an RF power amplifier, since using a single bipolar transistor as anon-linear amplifier may have a very predictable "RF power to DC output voltage" transfer characteristic. Therefore, calibrating at one RF power level may offers good reproducibility over a wide range of power levels. Furthermore a calibration using a RF power level determined using the RF power detector 100 may offer reproducibility over a wide temperature range. In particular if resistor R2 in the non-linear amplifier 120 has similar temperature dependency as any resistor in the bias circuit (not shown) that generates the bias current Io of equation (1).

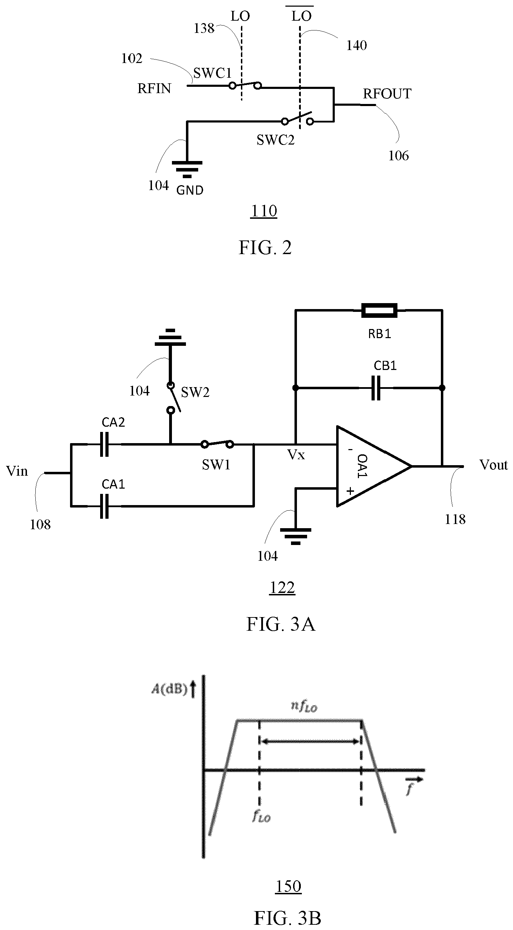

Figure 2 shows a detail of the chopper circuit 110. The RF input 102 is connected to the chopper output 106 via a first switch SWC1 controlled by first chopper clock input 138. The ground 104 is connected to the chopper output 106 via a second switch SWC2 controlled by the second chopper clock input 140. The first and second chopper switches SWC1 and SWC2 may for example be implemented using MOS transistors having the respective clock inputs 138, 140 connected to the respective MOS transistor gate. In operation, a clock signal $LO$ is applied to the first chopper clock input 138 and an inverse of the clock signal $\overline{LO}$ is applied to the second chopper clock input 140. The chopper output is coupled to the RF input 102 via first switch SWC1 in a first phase of the clock cycle and coupled to the ground 104 via second switch SWC2 in a second phase of clock cycle.

Figure 3A shows an example implementation of a variable gain amplifier and filter circuit 122. In some examples a number of stages, for example four stages, may be arranged in series to give the required gain variation and/or the frequency response. The variable gain amplifier and filter 122 may have an input connected to the non-linear amplifier output 108. A capacitor CB1 and resistor RB1 may be connected in parallel between the variable gain amplifier output 118 and an inverting input of an operational amplifier OA1. A series arrangement of a capacitor CA2 and switch SW1 may be connected between the inverting input of the operational amplifier OA1 and the non-linear amplifier output 108. A capacitor CA1 may be connected between the non-inverting input of the operational amplifier OA1 and the non-linear amplifier output 108. A switch SW2 may be connected between ground 104 and a common node between switch SW1 and capacitor CA2. In operation the switch SW1 may be open when the switch SW2 is closed and vice versa. The switches SW1, SW2 may be controlled by a control signal from a gain controller (not shown). In some examples the switches SW1, SW2 may be implemented by MOS transistors with the gates being controlled by the gain control signal.

During operation the capacitor $C_{A2}$ is either connected to ground or node $V_x$ at the inverting input of OA1 which allows the amplifier gain to be varied., The voltage gain at $f_{LO}$ is either $\dfrac{C_{A1}}{C_{B1}}$ when $C_{A2}$ is connected to ground 104 or $\dfrac{C_{A1}+C_{A2}}{C_{B1}}$ when $C_{A2}$ is connected to node $V_x$ Furthermore, both low-pass filtering and high-pass filtering is introduced in the variable gain amplifiers. Low-pass filtering is implemented to remove the now undesired RF signal and high-pass filtering or AC coupling is implemented to remove DC offsets in the amplifiers.

The frequency response 150 of the variable gain amplifier 122 is illustrated in Figure 3B. The frequency response pass-band includes the chopper frequency $f_{LO}$ and may have a bandwidth of an integer multiple n of the chopper frequency ($nf_{LO}$).

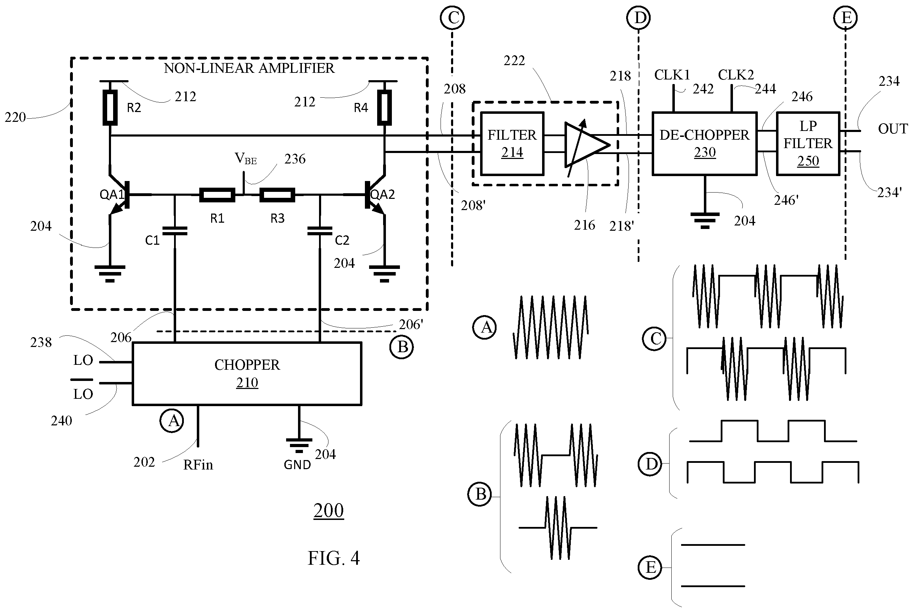

Figure 4 shows an RF power detector 200 according to an embodiment. The RF power detector 200 includes a chopper 210, a non-linear amplifier 220, a variable gain amplifier and filter 222, a de-chopper 230, and a low-pass filter 250.

The chopper 210 has a first input connected to an RF input 202 and a second input connected to a ground node or ground rail 204. The chopper 210 has a first chopper clock input 238 and a second chopper clock input 240, The first chopper clock input 238 may be configured to receive a clock LO and the second chopper clock input 240 may be configured to receive a second clock $\overline{LO}$ which is the inverse of LO. A first chopper output 206 may be connected to a first input of the non-linear amplifier 220. A second chopper output 206' may be connected to a second input of the non-linear amplifier 220.

The non-linear amplifier 220 may include an NPN bipolar transistor QA1 having a base connected to a bias voltage supply 236 via a resistor R1. The base of QA1 may also be connected to the first chopper output 206 via a capacitor C1. The emitter of transistor QA1 may be connected to the ground node 204. The collector of the transistor QA1 may be connected to the first non-linear amplifier output 208 and may also be connected to a supply voltage node or supply voltage rail 212 via a resistor R2.

The non-linear amplifier 220 may include an NPN bipolar transistor QA2 having a base connected to a bias voltage supply 236 via a resistor R3. The base of QA2 may also be connected to the second chopper output 206' via a capacitor C2. The emitter of transistor QA2 may be connected to the ground node 204. The collector of the transistor QA2 may be connected to the second non-linear amplifier output 208' and may also be connected to a supply voltage node or supply voltage rail 212 via a resistor R4.In other examples, PNP bipolar transistors may be used instead of NPN bipolar transistors.

The non-linear amplifier outputs 208, 208' may be connected to a filter 214 which may be a bandpass or high pass filter. The outputs of the filter 214 may be connected to a variable gain amplifier 216. The variable gain amplifier 216 and filter 214 may be combined in a single filter and amplifier 222. The variable gain amplifier output 218, 218' may be connected to the input of the de-chopper 230. The de-chopper 230 may have first de-chopper clock input 242 and second de-chopper clock input 244. The first de-chopper clock input 242 may be configured to receive a clock CLK1 and the second chopper clock input 240 may be configured to receive a second clock CLK2 which is the same frequency as CLK1. Clocks CLK1 and CLK2 may be non-overlapping clocks. The de-chopper outputs 246, 246' may be connected to respective inputs 246, 246' of the low pass filter 250. The low pass filter outputs may be connected to the RF power detector outputs 234, 234'.

In operation, the RF detector 200 may receive an RF signal on the RF input 202 shown as an example waveform A. The chopper 210 may chop the RF signal at a frequency ($f_{LO}$) which is much less than the RF frequency, for example a frequency of 1 MHz giving the output as shown in waveforms B. The chopping frequency as shown has a 50% duty cycle. The chopped RF signal on the respective first and second chopper outputs 206,206' is AC-coupled via the respective capacitors C1, C2 to the non-linear amplifier 220 in order to remove any DC component.

The RF voltage is converted to DC current in the non-linear amplifier 210. The DC current depends on the chopped signal stage and is increased when the RF is applied and decreased when the RF is not applied. Waveform C shows the resulting output voltage for each of the non-linear amplifier outputs 208, 208'. Note that in waveform C, the RF signal is still present. However, this is no longer the signal of interest and is filtered by the filter 314. The variable gain amplifier 316 may adapt the gain so that a wide dynamic range can be digitally post-processed for example by an ADC (not shown) having an analog input connected to the RF power detector outputs 234, 234' and a digital signal processor (not shown) connected to the ADC digital output. The output from the amplifier and filter 222 is shown by waveforms D. The signal is then de-chopped in the analog domain by de-chopper 230 to convert the signal from the chopper frequency $f_{LO}$ to DC. The low pass filter 250 removes any transients and the DC signal shown by waveform E is output on the detector outputs 234,234'. The DC voltage may then be measured by an ADC (not shown) connected to the detector outputs 234,234' and converted to a value for RF power for example using software running on a DSP (not shown). Since the de-chopping is done in the analog domain for RF detector 200, the sample frequency for the analog to digital conversion may be much lower than for RF detector 100.

The RF power detector 200 may provide true RF RMS power detection with a large dynamic range which may for example 50 dB compared to typical power detectors which have a dynamic range of about 20 dB. The RF power detector 200 may use chopping and de-chopping to remove DC offsets due to the transistors QA1, QA2 in the non-linear amplifier 210 used for RF Power detection. Removing the DC offsets may result in a more accurate power detector with wide dynamic range.

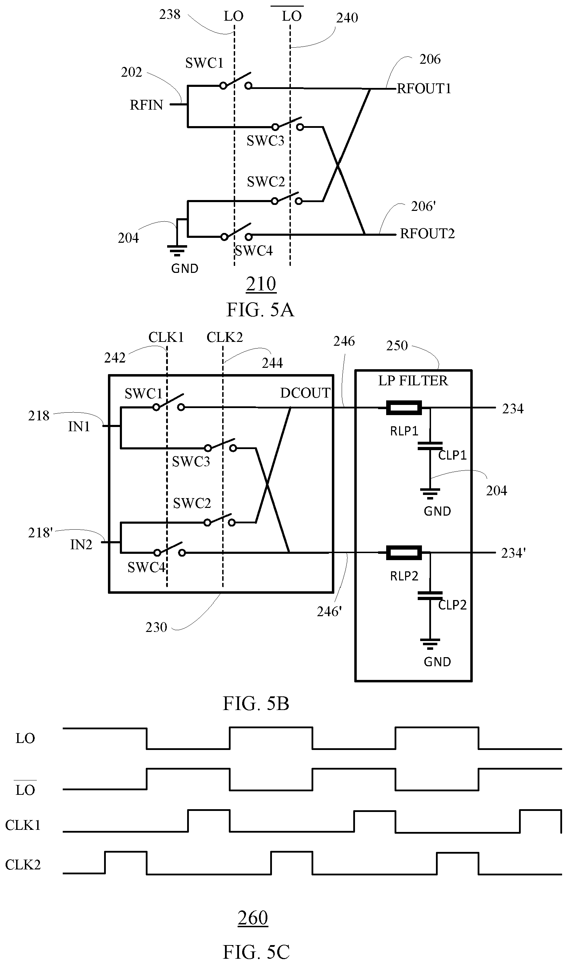

Figure 5A shows an example implementation of the chopper circuit 210. The RF input 202 is connected to the first chopper output 206 via a first switch SWC1 controlled by first chopper clock input 238. The ground 204 is connected to the first chopper output 206 via a second switch SWC2 controlled by the second chopper clock input 240.

The RF input 202 is connected to the second chopper output 206' via a third switch SWC3 controlled by second chopper clock input 240. The ground 204 is connected to the second chopper output 206' via a fourth switch SWC4 controlled by the first chopper clock input 238.

The chopper switches SWC1, SWC2, SWC3, SWC4 may for example be implemented using MOS transistors having the respective clock inputs 238, 240 connected to the respective MOS transistor gate. In operation, a clock signal *LO* is applied to the first chopper clock input 238 and an inverse of the clock signal $\overline{LO}$ is applied to the second chopper clock input 240. The first chopper output 206 is coupled to the RF input 202 via first switch SWC1 in a first phase of the clock cycle (LO active) and coupled to the ground 204 via second switch SWC2 in a second phase of clock cycle ($\overline{LO}$ active). The second chopper output 206' is coupled to the RF input 202 via third switch SWC3 in a second phase of the clock cycle and coupled to the ground 204 via further switch SWC4 in a first phase of the clock cycle.

Figure 5B shows an example implementation of the de-chopper circuit 230 and low pass filter 250. The de-chopper circuit 230 has a similar arrangement to chopper circuit 210.

The first variable gain amplifier output 218 is connected to the first de-chopper output 246 via a first switch SWC1 controlled by first de-chopper clock input 242. The second variable gain amplifier output 218' is connected to the first de-chopper output 246 via a second switch SWC2 controlled by the second de-chopper clock input 244.

The first variable gain amplifier output 218 is connected to the second de-chopper output 246' via a third switch SWC3 controlled by second de-chopper clock input 244. The second variable gain amplifier output 218' is connected to the second de-chopper output 246' via a fourth switch SWC4 controlled by the first de-chopper clock input 244.

The chopper switches SWC1, SWC2, SWC3, SWC4 may for example be implemented using MOS transistors having the respective clock inputs 242, 244 connected to the respective MOS transistor gate. In operation, a first clock signal *CLK1* is applied to the first de-chopper clock input 242 and a second clock signal *CLK2* is applied to the second de-chopper clock input 244. Clock signals CLK1 and CLK2 may have non-overlapping active phases and may be the same frequency is the chopper clock signal LO.

The first de-chopper output 246 is coupled to the first variable gain amplifier output 218 via first switch SWC1 during the active phase of CLK1 and coupled to the second variable gain amplifier output 218' via second switch SWC2 during the active phase of CLK2.

The second de-chopper output 246' is coupled to the first variable gain amplifier output 218 via third switch SWC3 during the active phase of CLK2 and coupled to the second variable gain amplifier output 218' via fourth switch SWC4 during the active phase of CLK1.

The low pass filter 250 may have a first resistor RLP1 connected between the first de-chopper output 246 and the first RF power detector output 234. A first capacitor CLP1 may be connected between first RF power detector output 234 and ground 204. A first resistor RLP1 may be connected between the second de-chopper output 246' and the second RF power detector output 234'. A second capacitor CLP2 may be connected between second RF power detector output 234'and ground 204.

Figure 5C shows example waveforms 260 of the chopper and de-chopper clocks. Chopper clock LO and inverse chopper clock $\overline{LO}$ may have a 50% duty cycle. The first de-chopper clock CLK1 and the second de-chopper clock CLK2 may have a 25% duty cycle.

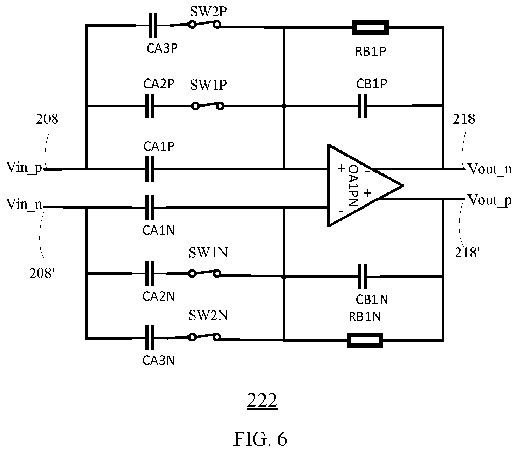

Figure 6 shows an example implementation of a variable gain amplifier and filter 222. In some examples a number of stages, for example four stages, may be arranged in series to give the required gain variation and/or the frequency response. The variable gain amplifier and filter 222 may have a first input (Vin_p) connected to the non-linear amplifier output 208. The variable gain amplifier and filter 222 may have a second input (Vin n) connected to the second non-linear amplifier output 208'.

A capacitor CB1N and resistor RB1N may be connected in parallel between the non-inverting variable gain amplifier output 218' and an inverting input of an operational amplifier OA1PN.

A capacitor CA1N may be connected between the inverting input of the operational amplifier OA1PN and the second non-linear amplifier output 208'.A series arrangement of a capacitor CA2N and switch SW1N may be connected between the inverting input of the operational amplifier OA1PN and the second non-linear amplifier output 208'. A series arrangement of a capacitor CA3N and switch SW2N may be connected between the inverting input of the operational amplifier OA1PN and the second non-linear amplifier output 208'.

A capacitor CB1P and resistor RB1P may be connected between the inverting variable gain amplifier output 218 and a non-inverting input of the operational amplifier OA1PN.

A capacitor CA1P may be connected between the noninverting input of the operational amplifier OA1PN and the first non-linear amplifier output 208. A series arrangement of a capacitor CA2P and switch SW1P may be connected between the noninverting input of the operational amplifier OA1PN and the first non-linear amplifier output 208. A series arrangement of a capacitor CA3P and switch SW2P may be connected between the non-inverting input of the operational amplifier OA1PN and the first non-linear amplifier output 208.

In some examples the switches SW1N, SW1P, SW2N, SW2P may be implemented by MOS transistors with the gates being controlled by one or more gain control signals. Amplifier and filter 222 implements a differential circuit which functions in a similar way with a similar frequency response to amplifier and filter 122. The gain may be varied by switch capacitances CA2N, CA3N, CA2P, CA3P in and out of circuit by controlling respective switches SW1N, SW1P, SW2N, SW2P.

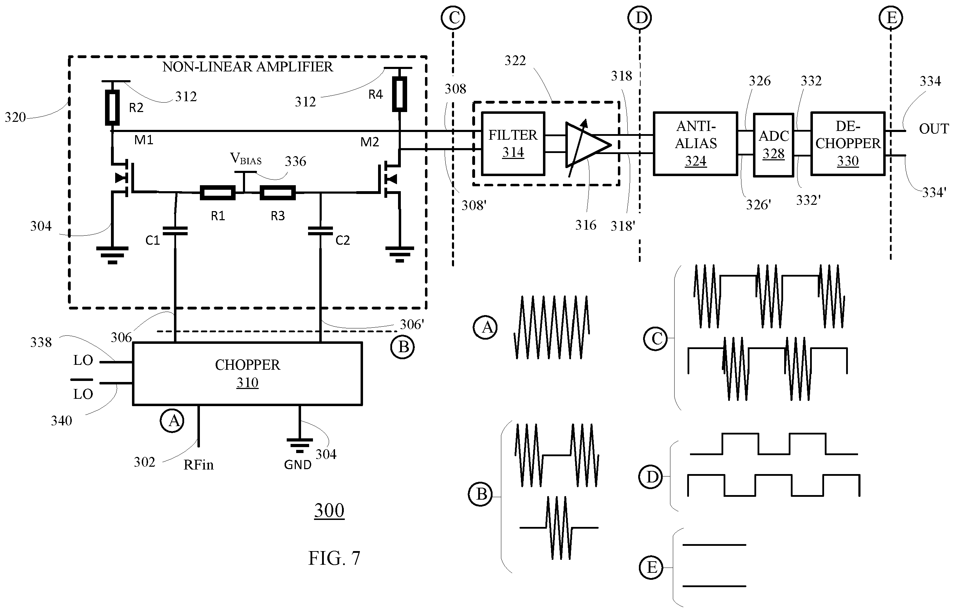

Figure 7 shows an RF power detector 300 according to an embodiment. The RF power detector 300 includes a chopper 310, a non-linear amplifier 320, a variable gain amplifier and filter322, an anti-alias low-pass filter 324, an analog-to-digital converter (ADC) 328, and a de-chopper 330.

The chopper 310 has a first input connected to an RF input 302 and a second input connected to a ground node or ground rail 304. The chopper 310 as a first chopper clock input 338 and a second chopper clock input 340 which may be configured to receive a clock which may be the inverse of the first chopper clock input. A first chopper output 306 may be connected to a first input of the non-linear amplifier 320. A second chopper output 306' may be connected to a second input of the non-linear amplifier 320.

The non-linear amplifier 320 may include an NMOS transistor M1 having a gate connected to a bias voltage supply 336 via a resistor R1. The gate of transistor M1 may also be connected to the first chopper output 306 via a capacitor C1. The source of transistor M1 may be connected to the ground node 304. The drain of the transistor M1 may be connected to the first non-linear amplifier output 308 and may also be connected to a supply voltage node or supply voltage rail 312 via a resistor R2.

The non-linear amplifier 320 may include an NMOS transistor M2 having a gate connected to a bias voltage supply 336 via a resistor R3. The gate of M2 may also be connected to the second chopper output 306' via a capacitor C2. The source of transistor M2 may be connected to the ground node 304. The drain of the transistor M2 may be connected to the second non-linear amplifier output 308' and may also be connected to a supply voltage node or supply voltage rail 312 via a resistor R4.In other examples, PMOS transistors may be used.

The bias voltage supply 336 may be configured to bias the transistors M1 and |M2 in the saturation region of operation, either in weak or in strong inversion, so that the non-linear amplifier 320 operates in a similar way to non-linear amplifier 220.

The non-linear amplifier outputs 308, 308' may be connected to a filter 314 which may be a bandpass or high pass filter. The outputs of the filter 314 may be connected to a variable gain amplifier 316. The variable gain amplifier 316 and filter 314 may be combined in a single filter and amplifier 322. The combined filter amplifier output 318, 318' may be connected to respective inputs of an anti-alias low pass filter 324. The anti-alias filter outputs 326, 326' may be connected to respective inputs of ADC 328. The ADC outputs 332, 332' may be connected to input of the de-chopper 330. The de-chopper outputs may be connected to the RF power detector outputs 334, 334'.

In operation, the RF detector 300 may receive an RF signal on the RF input 202 shown as an example waveform A. The chopper 310 which may be implemented similarly to chopper 210 may chop the RF signal at a frequency ($f_{LO}$) which is much less than the RF frequency, for example a frequency of 1 MHz giving the output as shown in waveforms B. The chopping frequency as shown has a 50% duty cycle. The chopped RF signal on the respective first and second chopper outputs 306,306' is AC-coupled via the respective capacitors C1, C2 to the non-linear amplifier 320 in order to remove any DC component.

The RF voltage is converted to DC current in the non-linear amplifier 320 in a similar way to non-linear amplifier 220 and the resulting output is shown by waveform C for each of the non-linear amplifier outputs 308, 308' . The RF signal present in the waveform C is then filtered by the filter 314. The variable gain amplifier 316 may adapt the gain so that a wide dynamic range can be digitally post-processed. The output from the amplifier and filter 322 is shown by waveforms D. The signal is then de-chopped in the digital domain by de-chopper 330 after conversion via anti-alias filter 324 and ADC 328 resulting in a digital DC value shown by waveform E on the detector outputs 234,234'. The DC voltage value may then be converted to a value for RF power for example using software running on a DSP (not shown).

The RF power detector 300 may provide true RF RMS power detection with a large dynamic range which may for example 50 dB compared to typical power detectors which have a dynamic range of about 20 dB. The RF power detector 300 uses chopping to remove DC offsets due to the transistors M1, M2 in the non-linear amplifier 320 used for RF Power detection which allows a more accurate power detector with wide dynamic range.

In other examples, the RF power detector may use the non-linear amplifier 320 and de-chopper in the analog domain similarly to RF power detector 200.

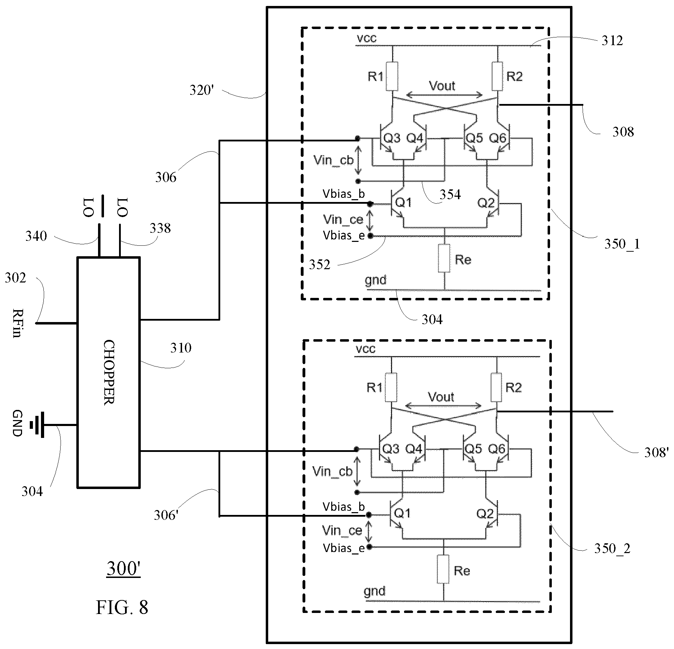

Figure 8 shows RF power detector 300'. The RF power detector 300' is the same as RF power detector 300 apart from the non-linear amplifier 320'. The non-linear amplifier 320' includes a multiplier to square the chopped input signal. The multiplier in non-linear amplifier 320' is implemented using two Gilbert cells 350_1, 350_2. Each Gilbert cell 350_1, 350_2 may include six NPN bipolar transistors Q1-Q6. Each Gilbert cell 350_1, 350 2 is configured with emitter coupled transistor pairs Q3, Q4 and Q5, Q6. The collectors of Q3 and Q5 are connected to supply 312 via resistor R1. The collectors of Q4 and Q5 are connected to the respective chopper output 308, 308' and to the supply 312 via resistor R2. Collector of transistor Q1 is coupled to the emitters of Q3 and Q4. Collector of transistor Q2 is coupled to the emitters of Q5 and Q6. The emitters of transistors Q1 and Q2 are connected to ground 304 via resistor Re.

The first chopper output 306 to the base of transistors Q1 and Q3 in Gilbert cell 350_1. The second chopper output 306' is connected to the base of transistors Q1 and Q3 in Gilbert cell 350_2. A first bias supply 352 is connected to the base of transistor Q2 in each Gilbert cell 350_1, 350_2. A second bias supply 354 is connected to the base of transistors Q4 and Q5 in each Gilbert cell 350_1, 350_2.

In operation each Gilbert cell 350_1, 350_2 may act as a multiplier and is used to square the received chopped signal.

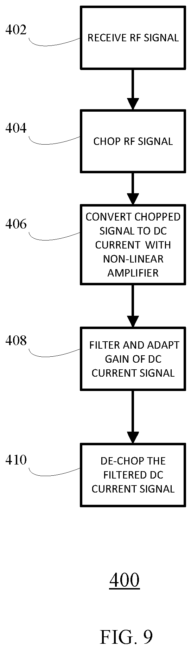

Figure 9 illustrates a method of RF power detection 400. In step 402 an RF signal is received. In step 404 the RF signal is chopped at a frequency much lower than the RF signal. In step 406 the chopped signal is converted to current with a non-linear amplifier which may output a signal including a DC current corresponding to an RMS voltage value of the RF signal. In step 408, the signal from the non-linear amplifier may be filtered with a band-pass filter to remove the RF signal frequency and DC offset due to the transistors in the non-linear amplifier and the gain adapted. In step 410, the signal may be de-chopped to recover a DC value corresponding to the power level of the received RF signal.

The method of RF power detection 400 allows RF power detection with a large dynamic range. The non-linear amplifier may use the non-linearity of a bipolar transistor or other means to perform RMS detection and RF to DC conversion. This non-linear amplifier may be combined with chopping (and de-chopping) to perform RF to a lower (chopping) frequency $f_{LO}$ conversion instead of conventional RF to DC conversion. The chopping frequency $f_{LO}$ may be lower than the RF frequency, for example 1 MHz. Filtering the output of the non-linear amplifier with a band-pass filter may remove the remaining RF signal frequencies which are no longer required and also remove any DC offset due to the transistors in the non-linear amplifier which may improve the sensitivity and accuracy. Applying variable gain to the non-linear amplifier output may allow a signal with a large dynamic range to be converted to a digital signal for post-processing.

Embodiments of the RF power detector may be used in RF ICs where measurement of RF power is required either in application or during production test. For example RF receiver products may include an RF power detector at the output of a Low Noise Amplifier. In other examples embodiments of the power detector may be included in RF transmitter or transceiver devices coupled to the output of an RF power amplifier. In some examples, a non-linear circuit may be used instead of non-linear amplifier to create a DC signal dependent on the RF signal amplitude. The non-linear circuit may be implemented using for example a diode, a bipolar transistor, a MOS, a GaAs transistor, a Gilbert Cell, a nonlinear resistor, a trans-linear circuit or any other non-linear circuit element with even-order non-linearity.

A Radio Frequency (RF) power detector and method is described. an RF input is configured to receive an RF signal and a chopper coupled to the RF input is configured to output a chopped RF signal. A non-linear element is configured to receive the chopped RF signal and to output a signal corresponding to an RMS power level of the RMS signal. A variable gain amplifier and filter includes an input coupled to the non-linear amplifier output and a variable gain amplifier output to filter and adapt the gain of a signal received from the non-linear amplifier output. A de-chopper is coupled to the variable gain amplifier and provides a signal corresponding to the RF power of the received RF signal.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

TABLE OF REFERENCE SIGNS

| 100 | RF power detector |
|---|---|
| 102 | RF input |
| 104 | Ground node/rail |
| 106 | chopper output |
| 108 | non-linear amplifier output |
| 110 | chopper |
| 112 | Supply voltage node/rail |
| 114 | Band-pass filter |
| 116 | Variable gain amplifier |
| 118 | Variable gain amplifier output |
| 120 | Non-linear amplifier |
| 122 | Filter and variable gain amplifier |
| 124 | Anti-alias (low-pass) filter |
| 126 | Anti-alias filter output |
| 128 | Analog-to-digital converter |
| 130 | De-chopper |
| 132 | ADC output |
| 134, 134' | RF detector outputs |

(continued)

| | |
|---|---|
| 136 | Bias voltage supply/node |
| 138 | First chopper clock input |
| 140 | Second chopper clock input |
| 142 | DC reference region waveform C |
| 144 | Power detection region waveform C |
| QA1 | NPN bipolar transistor |
| R1 | Resistor |
| R2 | Resistor |
| C1 | Capacitor |
| SWC1 | First chopper switch |
| SWC2 | Second chopper switch |
| RB1 | Resistor for combined filter amplifier circuit |
| CA1, CA2, CB1 | Capacitors, for combined filter amplifier circuit |
| SW1, SW2 | Switches for combined filter amplifier circuit |
| OA1 | Operational amplifier circuit |
| 150 | Frequency response for variable gain amplifier and filter circuit |
| | |
| | |
| 200 | RF power detector |
| 202 | RF input |
| 204 | Ground node/rail |
| 206,206' | chopper outputs |
| 208,208' | non-linear amplifier outputs |
| 210 | chopper |
| 212 | Supply voltage node/rail |
| 214 | Band-pass filter |
| 216 | Variable gain amplifier element |
| 218,218' | Variable gain amplifier outputs |
| 220 | Non-linear amplifier |
| 222 | Variable gain amplifier and filter |
| 230 | De-chopper |
| 234,234' | RF detector outputs |
| 236 | Bias voltage supply/node |
| 238 | First chopper clock |
| 240 | Second chopper clock |
| 242 | De-chopper first clock |
| 244 | De-chopper second clock |
| 246, 246' | De-chopper outputs |

(continued)

| 250 | RF detector outputs |
|---|---|
| QA1, QA2 | NPN bipolar transistors |
| R1, R2, R3, R4 | Resistors |
| C1, C2 | Capacitors |
| SWC1 | First chopper/de-chopper switch |
| SWC2 | Second chopper/de-chopper switch |
| SWC3 | Third chopper/de-chopper switch |
| SWC4 | Fourth chopper/de-chopper switch |
| RLP1, RLP2 | Resistors |
| CLP1,CLP2 | Capacitors |
| CA1P, CA2P, CA3P, CA4P CA1N, CA2N, CA3N, CA4N | Capacitors, for combined filter amplifier circuit |
| SW1P, SW2P, SW1N, SW2N | Switches for combined filter amplifier circuit |
| RA1P, RAIN | resistors |
| OA1PN | Operational amplifier circuit with differential outputs |
| 300 | RF power detector |
| 302 | RF input |
| 304 | Ground node/rail |
| 306,306' | chopper outputs |
| 308,308' | non-linear amplifier outputs |
| 310 | chopper |
| 312 | Supply voltage node/rail |
| 314 | Band-pass filter |
| 316 | Variable gain amplifier element |
| 318,318' | Variable gain amplifier outputs |
| 320 | Non-linear amplifier |
| 322 | Variable gain amplifier |
| 324 | Anti-alias (low-pass) filter |
| 326,326' | Anti-alias filter output |
| 328 | Analog-to-digital converter |
| 330 | De-chopper |
| 332,332' | ADC outputs |
| 334,334' | RF detector outputs |
| 336 | Bias voltage supply/node |
| 338 | First chopper clock input |
| 340 | Second chopper clock input |
| M1, M2 | NMOS transistors |
| R1, R2, R3, R4 | Resistors |
| C1, C2 | Capacitors |

(continued)

|  |  |
|---|---|
| 300' | RF power detector |
| 350_1, 350_2 | gilbert cell multiplier |
| 352 | Emitter bias supply node |
| 354 | Base bias supply node |
| Q1,Q2, Q3, Q4, Q5, Q6 | NPN transistors |
| R1,R2, Re | resistors |
|  |  |
| 400 | Method of RF power detection |
| 402 | Receive RF signal |
| 404 | Chop RF signal |
| 406 | Convert chopped signal to DC current |
| 408 | Filter and adapt gain of DC current signal |
| 410 | De-chop the filtered DC current signal |

**Claims**

1. A radio-frequency, RF, power detector comprising:

    an RF input configured to receive an RF signal;
    a chopper coupled to the RF input and configured to output a chopped RF signal;
    a non-linear element configured to receive the chopped RF signal; and to output a signal corresponding to an RMS power level of the RMS signal;
    a variable gain amplifier and filter having an input coupled to the non-linear amplifier output and a variable gain amplifier output and configured to filter and adapt the gain of a signal received from the non-linear amplifier output;
    a de-chopper coupled to the variable gain amplifier and configured to provide a signal corresponding to the RF power of the received RF signal.

2. The RF power detector of claim 1 wherein the non-linear element is configured as a non-linear amplifier, the non-linear amplifier comprising a bipolar transistor having a base coupled to the output of the chopper via a capacitor, a collector coupled to the input of the variable gain amplifier and a resistance arranged between a bias supply rail and the transistor base.

3. The RF power detector of any preceding claim wherein the chopper comprises a first switch arranged between the RF input and the chopper output and a second switch arranged between a reference supply and the chopper output and wherein the chopper is configured to couple the RF input to the chopper output during a first phase of a clock signal and to couple the reference supply to the chopper output during a second phase of the clock signal.

4. The RF power detector of any preceding claim wherein the variable gain amplifier and filter comprises a plurality of variable gain amplifier stages.

5. The RF power detector of claim 4 wherein the variable gain amplifier stage comprises a serial arrangement of a first capacitance and a first switch between a variable gain amplifier stage input and an inverting input of an operational amplifier; a second switch arranged between a supply node and a common node with the first capacitance and the first switch; a second capacitance coupled between the variable gain amplifier stage input and the inverting input of an operational amplifier; a parallel arrangement of a third capacitance and resistance between the operational amplifier output and the operational amplifier inverting input and a ground node coupled to the operational amplifier non-inverting input.

**6.** The RF power detector of any preceding claim wherein the de-chopper is coupled to the variable gain amplifier via an analog to digital converter and is configured to digitally de-chop the output signal of the variable gain amplifier to provide the RF power signal.

**7.** The RF power detector of claim 1 wherein the chopper comprises a first and second chopper output, the non-linear element is configured as a differential non-linear amplifier, the variable gain amplifier comprises a pair of inputs and outputs, the de-chopper comprises a pair of de-chopper inputs and a pair of de-chopper outputs.

**8.** The RF power detector of claim 7 wherein the differential non-linear amplifier comprises a pair of bipolar transistors having a base coupled to a respective output of the chopper via a respective capacitor, a collector coupled to a respective input of the variable gain amplifier and a respective resistance arranged between a bias supply rail and the transistor base.

**9.** The RF power detector of claim 7 or 8 wherein the chopper comprises a first switch arranged between the RF input and the first chopper output, a second switch arranged between a reference supply and the chopper output, a third switch arranged between the RF input and the second chopper output, a fourth switch arranged between a reference supply and the chopper output, wherein the chopper is configured to couple the RF input to the first chopper output and to couple the reference supply to the second chopper output during a first phase of a clock signal and to couple the RF input to the second chopper output and the reference supply to the first chopper output during a second phase of the clock signal.

**10.** The RF power detector of any preceding claim wherein the variable gain amplifier comprises one or more variable gain amplifier stages, each variable gain amplifier stage comprising:
a parallel arrangement of a first capacitance and resistance between the inverting operational amplifier output and the operational amplifier non-inverting input; and
a parallel arrangement of:

a first serial arrangement of a second capacitance and a first switch between a first variable gain amplifier stage input and a non-inverting input of an operational amplifier;
a second serial arrangement of a third capacitance and a second switch between the first variable gain amplifier stage input and the non-inverting input of the operational amplifier; and
a third capacitance coupled between the first variable gain amplifier stage input and a non-inverting input of an operational amplifier; and
each variable gain amplifier stage further comprising:

a parallel arrangement of a fifth capacitance and resistance between the operational amplifier non-inverting output and the operational amplifier inverting input; and

a parallel arrangement of:

a third serial arrangement of a sixth capacitance and a third switch between a second variable gain amplifier stage input and the inverting input of the operational amplifier;
a fourth serial arrangement of a seventh capacitance and a fourth switch between the second variable gain amplifier stage input and the inverting input of the operational amplifier;
an eighth capacitance coupled between the second variable gain amplifier stage input and the inverting input of the operational amplifier.

**11.** The RF power detector of any of claims 7 to 10 wherein the de-chopper comprises a first switch arranged between the first variable gain amplifier output and the first de-chopper output, a second switch arranged between the first variable gain amplifier output and the second de-chopper output, a third switch arranged between the second variable gain amplifier output and the first de-chopper output, a fourth switch arranged between the second variable gain amplifier output and the second de-chopper output, wherein the de-chopper is configured to couple the first variable gain amplifier output to the first de-chopper output and to couple the second variable gain amplifier output to the second de-chopper output during an active phase of a first clock signal and configured to couple the first variable gain amplifier output to the second de-chopper output and to couple the second variable gain amplifier output to the first de-chopper output during an active phase of a second clock signal, wherein the active phases of the first and second clock signals are non-overlapping.

**12.** The RF power detector of any of claims 7 to 11 further comprising a low pass filter coupled to the de-chopper outputs.

**13.** The RF power detector of claim 12 wherein the low pass filter further comprises a series arrangement of a resistance and a capacitance coupled between each RF power detector output and a ground node.

**14.** The RF power detector of any of claims 7 to 13 further comprising an analog-to-digital convertor coupled to the RF power detector output

**15.** The RF power detector of any preceding claim wherein the non-linear element comprises one of a non-linear bipolar transistor amplifier, a non-linear MOS transistor amplifier, a gilbert-cell multiplier

FIG. 1

EP 4 009 060 A1

138 ∽ LO  $\overline{LO}$

102 ∽  140

SWC1

RFIN  RFOUT

SWC2

104 GND  106

110

FIG. 2

RB1

CB1

104  SW2

CA2

Vin  SW1  Vx  - OA1  Vout

CA1  +

108  104  118

122

FIG. 3A

A(dB)

$nf_{LO}$

$f_{LO}$  $f$

150

FIG. 3B

FIG. 4

200

210
FIG. 5A

FIG. 5B

260
FIG. 5C

222

FIG. 6

FIG. 7

300

FIG. 8

300'

**402** RECEIVE RF SIGNAL

**404** CHOP RF SIGNAL

**406** CONVERT CHOPPED SIGNAL TO DC CURRENT WITH NON-LINEAR AMPLIFIER

**408** FILTER AND ADAPT GAIN OF DC CURRENT SIGNAL

**410** DE-CHOP THE FILTERED DC CURRENT SIGNAL

400

FIG. 9

23

Europäisches
Patentamt

European
Patent Office

Office européen
des brevets

# EUROPEAN SEARCH REPORT

**Application Number**

EP 20 21 1317

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 656 929 A (HUMPHERYS MELVIN D [US]) 12 August 1997 (1997-08-12) * column 1, lines 59-60; figure 1 * * column 2, lines 8-15 * ----- | 1-15 | INV. G01R21/00 H04B17/10 H03F3/393 H03F3/45 |
| X | US 2005/046409 A1 (IVES FRED [US]) 3 March 2005 (2005-03-03) * paragraphs [0005], [0014] - [0016]; figure 1 * ----- | 1-15 | |
| A | KOUWENHOVEN M ET AL: "A 2GHz mean-square power detector with integrated offset chopper", SOLID-STATE CIRCUITS CONFERENCE, 2005. DIGEST OF TECHNICAL PAPERS. ISS CC. 2005 IEEE INTERNATIONAL SAN FRANCISCO, CA, USA FEB. 6-10, 2005, IEEE, PISCATAWAY, NJ, USA, 2 January 2005 (2005-01-02), pages 124-588Vol.1, XP031173677, DOI: 10.1109/ISSCC.2005.1493900 ISBN: 978-0-7803-8904-5 * abstract; figures 6.8.1-6.8.4 * ----- | 1-15 | |
| A | YIJUN ZHOU ET AL: "A wide band CMOS RF power detector", 2006 IEEE INTERNATIONAL SYMPOSIUM ON CIRCUITS AND SYSTEMS 21-24 MAY 2006 ISLAND OF KOS, GREECE, IEEE - PISCATAWAY, NJ, USA, 21 May 2006 (2006-05-21), pages 4pp-4231, XP032458685, DOI: 10.1109/ISCAS.2006.1693562 ISBN: 978-0-7803-9389-9 * abstract; figures 1, 4b * ----- | 1-15 | TECHNICAL FIELDS SEARCHED (IPC) G01R H04B H03F |
| A | US 4 628 256 A (POWELL ROBERT [US]) 9 December 1986 (1986-12-09) * abstract; figure 1 * ----- | 1-15 | |

The present search report has been drawn up for all claims

| Place of search | Date of completion of the search | Examiner |
|---|---|---|
| The Hague | 19 April 2021 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 20 21 1317

This annex lists the patent family members relating to the patent documents cited in the above-mentioned European search report.
The members are as contained in the European Patent Office EDP file on
The European Patent Office is in no way liable for these particulars which are merely given for the purpose of information.

19-04-2021

| Patent document cited in search report | | Publication date | Patent family member(s) | | Publication date |
|---|---|---|---|---|---|
| US 5656929 | A | 12-08-1997 | DE | 19623304 A1 | 30-04-1997 |
| | | | GB | 2306680 A | 07-05-1997 |
| | | | JP | 3909102 B2 | 25-04-2007 |
| | | | JP | H09138248 A | 27-05-1997 |
| | | | US | 5656929 A | 12-08-1997 |
| US 2005046409 | A1 | 03-03-2005 | JP | 2005077408 A | 24-03-2005 |
| | | | US | 2005046409 A1 | 03-03-2005 |
| US 4628256 | A | 09-12-1986 | NONE | | |

EPO FORM P0459

For more details about this annex : see Official Journal of the European Patent Office, No. 12/82